# EUROPÄISCHE PATENTSCHRIFT

(11) **EP 3 911 922 B1**
(45) Veröffentlichungstag und Bekanntmachung des Hinweises auf die Patenterteilung: **12.07.2023**
(21) Anmeldenummer: 19832655.5
(22) Anmeldetag: 19.12.2019
(51) Int. Cl.: G01D 3/08, G01D 18/00

(54) **VORRICHTUNG ZUM BEREITSTELLEN EINES SENSORSIGNALS ZUM AUSWERTEN FÜR EIN BREMSSYSTEM EINES FAHRZEUGS, VERFAHREN UND STEUERGERÄT ZUM AUSWERTEN EINES SENSORSIGNALS FÜR EIN BREMSSYSTEM EINES FAHRZEUGS UND BREMSSYSTEM FÜR EIN FAHRZEUG**
APPARATUS FOR PROVIDING A SENSOR SIGNAL FOR EVALUATION FOR A BRAKING SYSTEM OF A VEHICLE, METHOD AND CONTROL UNIT FOR EVALUATING A SENSOR SIGNAL FOR A BRAKING SYSTEM OF A VEHICLE, AND BRAKING SYSTEM FOR A VEHICLE
DISPOSITIF PERMETTANT DE DÉLIVRER UN SIGNAL DE DÉTECTION À ÉVALUER POUR UN SYSTÈME DE FREINAGE D'UN VÉHICULE, PROCÉDÉ ET APPAREIL DE COMMANDE PERMETTANT D'ÉVALUER UN SIGNAL DE DÉTECTION POUR UN SYSTÈME DE FREINAGE D'UN VÉHICULE ET SYSTÈME DE FREINAGE POUR UN VÉHICULE

(30) Priorität: 18.01.2019 DE 102019101352
(43) Veröffentlichungstag der Anmeldung: 24.11.2021
(73) Patentinhaber: KNORR-BREMSE Systeme für Nutzfahrzeuge GmbH, 80809 München (DE)
(72) Erfinder: SCHOLL, Frank, 74379 Ingersheim (DE); WINZ, Dieter, 72108 Rottenburg (DE)
(86) Internationale Anmeldenummer: PCT/EP2019/086233
(87) Internationale Veröffentlichungsnummer: WO 2020/148064

(56) Entgegenhaltungen:
- DE-A1- 19 911 526
- DE-A1-102006 050 832
- DE-A1-102009 046 450

## Beschreibung

Die vorliegende Erfindung bezieht sich auf eine Vorrichtung zum Bereitstellen eines Sensorsignals zum Auswerten für ein Bremssystem eines Fahrzeugs, Verfahren und Steuergerät zum Auswerten eines Sensorsignals für ein Bremssystem eines Fahrzeugs, Bremssystem für ein Fahrzeug Insbesondere bei einer Auswertung von sicherheitsrelevanten Sensorsignalen sollte ein Signalpfad einer Schaltung zur Auswertung regelmäßig geprüft werden. Üblicherweise wird hierbei das Sensorsignal insbesondere lediglich über einen Pfad erfasst. Eine Plausibilisierung kann hierbei lediglich über weitere Methoden erfolgen. Während der Prüfung beispielsweise mit Testsignalen oder Testmustern kann es dazu kommen, dass das eigentliche Sensorsignal nicht zur Verfügung steht bzw. nicht ohne weiteres auswertbar ist. DE 10 2009 046450 A1 zeigt ein bekannte Vorrichtung zur Bereitstellung eines Sensorsignals.

Vor diesem Hintergrund ist es die Aufgabe der vorliegenden Erfindung, eine verbesserte Vorrichtung zum Bereitstellen eines Sensorsignals zum Auswerten für ein Bremssystem eines Fahrzeugs, ein verbessertes Verfahren zum Auswerten eines Sensorsignals für ein Bremssystem eines Fahrzeugs, ein verbessertes Steuergerät und ein verbessertes Bremssystem für ein Fahrzeug zu schaffen.

Diese Aufgabe wird durch eine Vorrichtung zum Bereitstellen eines Sensorsignals zum Auswerten für ein Bremssystem eines Fahrzeugs, durch ein Verfahren zum Auswerten eines Sensorsignals für ein Bremssystem eines Fahrzeugs, durch ein entsprechendes Steuergerät, durch ein entsprechendes Computerprogramm und durch ein Bremssystem für ein Fahrzeug gemäß den Hauptansprüchen gelöst.

Gemäß Ausführungsformen kann insbesondere eine sichere Prüfung und Auswertung von Sensorsignalen ermöglicht werden. Hierbei können beispielsweise ein Signalpfad und eine Testschaltung doppelt ausgeführt und auf zwei unabhängige Auswerteeinheiten, insbesondere Analog-Digital-Wandler, geführt werden. Während auf einem der beiden Signalpfade ein Test durchgeführt wird, kann das Sensorsignal auf dem anderen Signalpfad weiterhin zur Verfügung stehen. Insbesondere kann eine Auswertung eines Drucksensorsignals eines Anhängersteuermoduls (TCM = Trailer Control Module) eines Nutzfahrzeugs ermöglicht werden. Der Signalpfad kann beispielsweise mindestens zweimal alle 50 Millisekunden getestet bzw. geprüft werden, wobei eine Auswertung des Sensorsignals beispielsweise weder unterbrochen noch verfälscht werden braucht.

Vorteilhafterweise kann gemäß Ausführungsformen insbesondere ein Sensorsignal kontinuierlich auch während eines Testmusters ausgewertet werden. So kann beispielsweise ein sicherheitsrelevantes Sensorsignal, zum Beispiel ein Spannungswert eines Drucksensors, über den einen Signalpfad ausgewertet werden und kann der jeweils andere Signalpfad geprüft werden. Eine Überprüfung beider Signalpfade kann hierbei regelmäßig nacheinander durch abwechselnden Betrieb erfolgen. So kann insbesondere eine Verfälschung oder mangelnde Verfügbarkeit eines Sensorsignals aufgrund von Testsignalen oder Testmustern verhindert werden. Es kann somit insbesondere auch eine Güte oder ein Zustand eines Analog-Digital-Wandlers geprüft werden.

Es wird eine Vorrichtung zum Bereitstellen eines Sensorsignals zum Auswerten für ein Bremssystem eines Fahrzeugs vorgestellt, wobei die Vorrichtung folgende Merkmale aufweist:
einen ersten Signalpfad zum Ausgeben des Sensorsignals an eine erste Ausgangsschnittstelle zu einer ersten Wandlereinrichtung, wobei der erste Signalpfad erste elektronische Bauelemente aufweist, wobei der erste Signalpfad elektrisch mit einer Eingangsschnittstelle zu einem Sensor des Fahrzeugs verbunden ist;
eine erste Testeinrichtung zum Beaufschlagen des Sensorsignals in dem ersten Signalpfad mit einem ersten Testsignal, wobei die erste Testeinrichtung elektrisch mit dem ersten Signalpfad verbindbar oder verbunden ist;
einen zweiten Signalpfad zum Ausgeben des Sensorsignals an eine zweite Ausgangsschnittstelle zu einer zweiten Wandlereinrichtung, wobei der zweite Signalpfad zweite elektronische Bauelemente aufweist, wobei der zweite Signalpfad elektrisch mit der Eingangsschnittstelle zu dem Sensor des Fahrzeugs verbunden ist; und
eine zweite Testeinrichtung zum Beaufschlagen des Sensorsignals in dem zweiten Signalpfad mit einem zweiten Testsignal, wobei die zweite Testeinrichtung elektrisch mit dem zweiten Signalpfad verbindbar oder verbunden ist.

Bei dem Fahrzeug kann es sich um ein Nutzfahrzeug handeln, wie beispielsweise einen Lastkraftwagen oder dergleichen. Der Sensor kann als ein Drucksensor oder anderer Sensor für das Bremssystem ausgeführt sein. Das Bremssystem kann ein Anhängersteuermodul aufweisen. Das Sensorsignal kann eine elektrische Spannung repräsentieren. Die erste Wandlereinrichtung kann als ein erster Analog-Digital-Wandler oder als ein erster Kanal eines Analog-Digital-Wandlers ausgeführt sein. Die zweite Wandlereinrichtung kann als ein zweiter Analog-Digital-Wandler oder als ein zweiter Kanal des Analog-Digital-Wandlers ausgeführt sein. An der Eingangsschnittstelle kann ein einziger Eingangssignalpfad vorliegen. Der Eingangssignalpfad an der Eingangsschnittstelle kann sich in den ersten Signalpfad und in den zweiten Signalpfad verzweigen, insbesondere an einem Verzweigungspunkt. Das erste Testsignal und das zweite Testsignal können eine identische Signalcharakteristik aufweisen. Jedes der Testsignale kann eine elektrische Spannung repräsentieren.

Gemäß einer Ausführungsform kann die erste Testeinrichtung eine erste elektrische Testspannungsquelle zum Erzeugen des ersten Testsignals und eine erste Schalteinrichtung zum signalübertragungsfähigen Verbinden der ersten Testeinrichtung mit dem ersten Signalpfad aufweisen. Die zweite Testeinrichtung kann eine zweite elektrische Testspannungsquelle zum Erzeugen des zweiten Testsignals und eine zweite Schalteinrichtung zum signalübertragungsfähigen Verbinden der zweiten Testeinrichtung mit dem zweiten Signalpfad aufweisen. Eine solche Ausführungsform bietet den Vorteil, dass eine abwechselnde Aufschaltung der Testsignale auf das Sensorsignal in den beiden Signalpfaden auf einfache und zuverlässige Weise realisiert werden kann.

Auch kann die erste Testeinrichtung einen ersten elektrischen Testwiderstand und zusätzlich oder alternativ eine Parallelschaltung aus einer oder zwei ersten Testdioden aufweisen. Die zweite Testeinrichtung kann einen zweiten elektrischen Testwiderstand und zusätzlich oder alternativ eine Parallelschaltung aus einer oder zwei zweiten Testdioden aufweisen. Eine solche Ausführungsform bietet den Vorteil, dass eine Überprüfung der Signalpfade sowie der Wandlereinrichtungen unaufwendig und sicher ermöglicht werden kann.

Insbesondere können die ersten elektronischen Bauelemente des ersten Signalpfades zwei erste elektrische Widerstände, die miteinander elektrisch in Reihe geschaltet sind, und eine erste Kapazität aufweisen. Die erste Testeinrichtung kann zwischen den ersten Widerständen elektrisch mit dem ersten Signalpfad verbunden sein. Die erste Kapazität kann zwischen den ersten Widerständen und der ersten Ausgangsschnittstelle elektrisch zwischen den ersten Signalpfad und Masse geschaltet sein. Die zweiten elektronischen Bauelemente des zweiten Signalpfades können zwei zweite elektrische Widerstände, die miteinander elektrisch in Reihe geschaltet sind, und eine zweite Kapazität aufweisen. Die zweite Testeinrichtung kann zwischen den zweiten Widerständen elektrisch mit dem zweiten Signalpfad verbunden sein. Die zweite Kapazität kann zwischen den zweiten Widerständen und der zweiten Ausgangsschnittstelle elektrisch zwischen den zweiten Signalpfad und Masse geschaltet sein. Eine solche Ausführungsform bietet den Vorteil, dass eine genaue Auswertung des Sensorsignals mit abwechselnder Prüfung und Auswertung pro Signalpfad auf einfache Weise realisiert werden kann.

Ferner kann die Vorrichtung einen elektrischen Eingangswiderstand aufweisen, der elektrisch zwischen die Eingangsschnittstelle und Masse geschaltet ist. Eine solche Ausführungsform bietet den Vorteil, dass eine Belastung des Sensorsignals durch die Vorrichtung auf einfache Weise dargestellt werden kann.

Es wird auch ein Verfahren zum Auswerten eines Sensorsignals für ein Bremssystem eines Fahrzeugs vorgestellt, wobei das Verfahren in Verbindung mit einer Ausführungsform der vorstehend genannten Vorrichtung ausführbar ist, wobei das Verfahren folgende Schritte aufweist:
Beaufschlagen lediglich des Sensorsignals in dem ersten Signalpfad mit dem ersten Testsignal;
Einlesen des mit dem ersten Testsignal beaufschlagten Sensorsignals von der ersten Ausgangsschnittstelle, um einen Test des ersten Signalpfades und der ersten Wandlereinrichtung durchzuführen, und des Sensorsignals von der zweiten Ausgangsschnittstelle, um das Sensorsignal auszuwerten;
Beaufschlagen lediglich des Sensorsignals in dem zweiten Signalpfad mit dem zweiten Testsignal; und
Einlesen des mit dem zweiten Testsignal beaufschlagten Sensorsignals von der zweiten Ausgangsschnittstelle, um einen Test des zweiten Signalpfades und der zweiten Wandlereinrichtung durchzuführen, und des Sensorsignals von der ersten Ausgangsschnittstelle, um das Sensorsignal auszuwerten.

Das Verfahren kann bzw. die Schritte des Verfahrens können unter Verwendung eines Steuergeräts ausgeführt werden. In den Schritten des Beaufschlagens kann ein Signalpegel des Sensorsignals durch Einspeisung des ersten Testsignals oder des zweiten Testsignals verändert werden. Hierbei kann ein Kurzschluss zu einem anderen Signal oder ein Defekt der ersten Wandlereinrichtung oder der zweiten Wandlereinrichtung erkannt werden. Zusätzlich oder alternativ kann in den Schritten des Beaufschlagens zumindest ein definierter Signalpegel im gültigen Messbereich eingespeist werden.

Der hier vorgestellte Ansatz schafft ferner ein Steuergerät, das ausgebildet ist, um die Schritte einer Variante eines hier vorgestellten Verfahrens in entsprechenden Einrichtungen durchzuführen, anzusteuern bzw. umzusetzen. Auch durch diese Ausführungsvariante der Erfindung in Form eines Steuergeräts kann die der Erfindung zugrunde liegende Aufgabe schnell und effizient gelöst werden.

Hierzu kann das Steuergerät zumindest eine Recheneinheit zum Verarbeiten von Signalen oder Daten, zumindest eine Speichereinheit zum Speichern von Signalen oder Daten, zumindest eine Schnittstelle zu einem Sensor oder einem Aktor zum Einlesen von Sensorsignalen von dem Sensor oder zum Ausgeben von Steuersignalen an den Aktor und/oder zumindest eine Kommunikationsschnittstelle zum Einlesen oder Ausgeben von Daten aufweisen, die in ein Kommunikationsprotokoll eingebettet sind. Die Recheneinheit kann beispielsweise ein Signalprozessor, ein Mikrocontroller oder dergleichen sein, wobei die Speichereinheit ein Flash-Speicher, ein EEPROM oder eine magnetische Speichereinheit sein kann. Die Kommunikationsschnittstelle kann ausgebildet sein, um Daten drahtlos und/oder leitungsgebunden einzulesen oder auszugeben, wobei eine Kommunikationsschnittstelle, die leitungsgebundene Daten einlesen oder ausgeben kann, diese Daten beispielsweise elektrisch oder optisch aus einer entsprechenden Datenübertragungsleitung einlesen oder in eine entsprechende Datenübertragungsleitung ausgeben kann.

Unter einem Steuergerät kann vorliegend ein elektrisches Gerät verstanden werden, das Sensorsignale verarbeitet und in Abhängigkeit davon Steuer- und/oder Datensignale ausgibt. Das Steuergerät kann eine Schnittstelle aufweisen, die hard- und/oder softwaremäßig ausgebildet sein kann. Bei einer hardwaremäßigen Ausbildung können die Schnittstellen beispielsweise Teil eines sogenannten System-ASICs sein, der verschiedenste Funktionen des Steuergeräts beinhaltet. Es ist jedoch auch möglich, dass die Schnittstellen eigene, integrierte Schaltkreise sind oder zumindest teilweise aus diskreten Bauelementen bestehen. Bei einer softwaremäßigen Ausbildung können die Schnittstellen Softwaremodule sein, die beispielsweise auf einem Mikrocontroller neben anderen Softwaremodulen vorhanden sind.

Es wird ferner ein Bremssystem für ein Fahrzeug vorgestellt, wobei das Bremssystem folgende Merkmale aufweist:
einen Sensor, wobei der Sensor ausgebildet ist, um ein Sensorsignal auszugeben;
eine Ausführungsform der vorstehend genannten Vorrichtung; und
eine Ausführungsform des vorstehend genannten Steuergerätes, wobei der Sensor über die Vorrichtung signalübertragungsfähig mit dem Steuergerät verbunden ist.

In Verbindung mit dem Bremssystem können eine Ausführungsform der vorstehend genannten Vorrichtung und eine Ausführungsform des vorstehend genannten Steuergeräts vorteilhaft eingesetzt oder verwendet werden, um eine Signalauswertung sowie eine Prüffunktion zu ermöglichen. Das Bremssystem kann ein Anhängersteuermodul zum Steuern von Bremsfunktionen eines Anhängers des Fahrzeugs aufweisen.

Gemäß einer Ausführungsform kann das Steuergerät die erste Wandlereinrichtung und die zweite Wandlereinrichtung aufweisen. Eine solche Ausführungsform bietet den Vorteil, dass eine zweikanalige Signalverarbeitung auf einfache und zuverlässige Weise ermöglicht werden kann.

Auch kann das Steuergerät zumindest Teile der ersten Testeinrichtung der Vorrichtung und zumindest Teile der zweiten Testeinrichtung der Vorrichtung aufweisen. Insbesondere kann das Steuergerät die Testspannungsquellen und die Schalteinrichtungen der Testeinrichtungen aufweisen. Eine solche Ausführungsform bietet den Vorteil, dass die Vorrichtung auch unter effizienter Einbeziehung oder Nutzung bereits ohnehin vorhandener Geräte realisiert werden kann.

Von Vorteil ist auch ein Computerprogrammprodukt oder Computerprogramm mit Programmcode, der auf einem maschinenlesbaren Träger oder Speichermedium wie einem Halbleiterspeicher, einem Festplattenspeicher oder einem optischen Speicher gespeichert sein kann und zur Durchführung, Umsetzung und/oder Ansteuerung der Schritte des Verfahrens nach einer der vorstehend beschriebenen Ausführungsformen verwendet wird, insbesondere wenn das Programmprodukt oder Programm auf einem Computer oder einer Vorrichtung ausgeführt wird.

Ausführungsbeispiele des hier vorgestellten Ansatzes werden in der nachfolgenden Beschreibung mit Bezug zu den Figuren näher erläutert. Es zeigen:
Fig. 1 eine schematische Darstellung eines Fahrzeugs mit einem Bremssystem gemäß einem Ausführungsbeispiel;
Fig. 2 eine schematische Darstellung eines Fahrzeugs mit einem Bremssystem gemäß einem Ausführungsbeispiel; und
Fig. 3 ein Ablaufdiagramm eines Verfahrens zum Auswerten gemäß einem Ausführungsbeispiel.

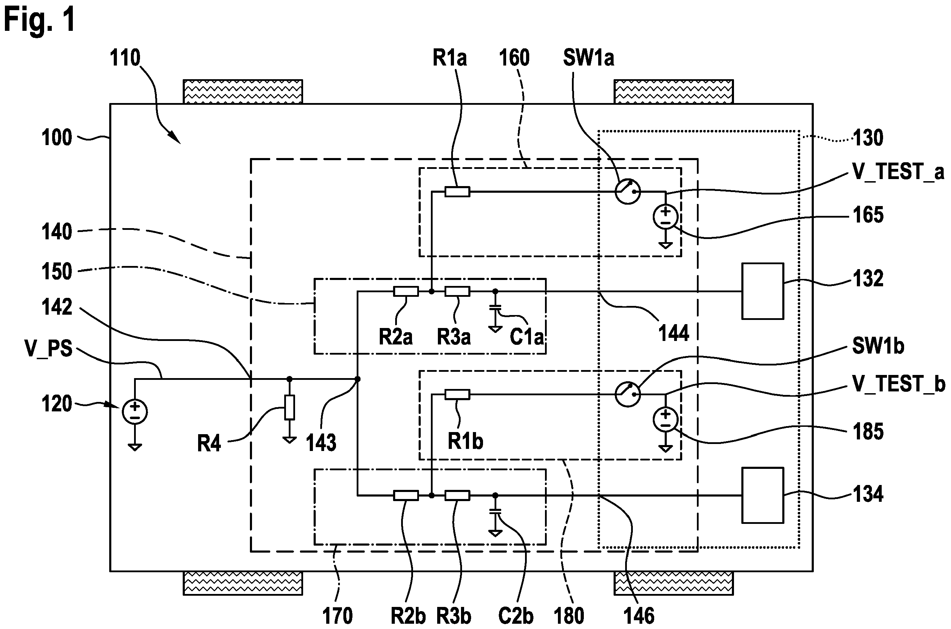

**Fig. 1** zeigt eine schematische Darstellung eines Fahrzeugs 100 mit einem Bremssystem 110 gemäß einem Ausführungsbeispiel. Das Fahrzeug 100 ist ein Kraftfahrzeug, beispielsweise ein Nutzfahrzeug, insbesondere ein Lastkraftwagen oder dergleichen. Von dem Bremssystem 110 sind gemäß dem hier dargestellten Ausführungsbeispiel beispielhaft lediglich ein Sensor 120, ein Steuergerät 130 und eine Vorrichtung 140 zum Bereitstellen bzw. eine Bereitstellungsvorrichtung 140 gezeigt.

Der Sensor 120 ist beispielsweise als ein Drucksensor ausgeführt. Insbesondere ist der Sensor 120 als ein Drucksensor für ein Anhängersteuermodul des Bremssystems 110 ausgeführt. Der Sensor 120 ist ausgebildet, um ein Sensorsignal V_PS auszugeben. Das Sensorsignal Sensorsignal V_PS kann hierbei eine elektrische Spannung bzw. elektrische Spannungswerte repräsentieren. Der Sensor 120 ist über die Bereitstellungsvorrichtung 140 signalübertragungsfähig mit dem Steuergerät 130 verbunden. Das Steuergerät 130 kann als ein Steuergerät des Bremssystems 110 oder für das Bremssystem 110 ausgeführt sein.

Die Bereitstellungsvorrichtung 140 bzw. Vorrichtung 140 zum Bereitstellen ist ausgebildet, um das Sensorsignal V_PS zum Auswerten für das Bremssystem 110 bereitzustellen. Die Bereitstellungsvorrichtung 140 weist einen ersten Signalpfad 150, eine erste Testeinrichtung 160, einen zweiten Signalpfad 170 und eine zweite Testeinrichtung 180 auf. Auch weist die Bereitstellungsvorrichtung 140 eine Eingangsschnittstelle 142, eine erste Ausgangsschnittstelle 144 und eine zweite Ausgangsschnittstelle 146 auf.

Der erste Signalpfad 150 ist ausgebildet, um das Sensorsignal V_PS an die erste Ausgangsschnittstelle 144 zu einer ersten Wandlereinrichtung auszugeben. Der erste Signalpfad 150 weist erste elektronische Bauelemente auf. Ferner ist der erste Signalpfad 150 elektrisch mit der Eingangsschnittstelle 142 zu dem Sensor 120 verbunden. Genauer gesagt ist der erste Signalpfad 150 elektrisch zwischen die Eingangsschnittstelle 142 und die erste Ausgangsschnittstelle 144 geschaltet. Somit ist die Eingangsschnittstelle 142 über den ersten Signalpfad 150 signalübertragungsfähig bzw. elektrisch mit der ersten Ausgangsschnittstelle 144 verbunden. Die erste Testeinrichtung 160 ist ausgebildet, um das Sensorsignal V_PS in dem ersten Signalpfad 150 mit einem ersten Testsignal V_TEST_a zu beaufschlagen. Dazu ist die erste Testeinrichtung 160 elektrisch bzw. signalübertragungsfähig mit dem ersten Signalpfad 150 verbunden.

Der zweite Signalpfad 170 ist ausgebildet, um das Sensorsignal V_PS an die zweite Ausgangsschnittstelle 146 zu einer zweiten Wandlereinrichtung auszugeben. Der zweite Signalpfad 170 weist zweite elektronische Bauelemente auf. Zudem ist der zweite Signalpfad 170 elektrisch mit der Eingangsschnittstelle 142 zu dem Sensor 120 verbunden. Genauer gesagt ist der zweite Signalpfad 170 elektrisch zwischen die Eingangsschnittstelle 142 und die zweite Ausgangsschnittstelle 146 geschaltet. Somit ist die Eingangsschnittstelle 142 über den zweiten Signalpfad 170 signalübertragungsfähig bzw. elektrisch mit der zweiten Ausgangsschnittstelle 146 verbunden. Die zweite Testeinrichtung 180 ist ausgebildet, um das Sensorsignal V_PS in dem zweiten Signalpfad 170 mit einem zweiten Testsignal V_TEST_b zu beaufschlagen. Dazu ist die zweite Testeinrichtung 180 elektrisch bzw. signalübertragungsfähig mit dem zweiten Signalpfad 170 verbunden.

Der erste Signalpfad 150 und der zweite Signalpfad 170 der Bereitstellungsvorrichtung 140 sind zueinander elektrisch parallel geschaltet. An einem Verzweigungspunkt 143 verzweigt sich ein Eingangssignalpfad von der Eingangsschnittstelle 142 her in den ersten Signalpfad 150 und den zweiten Signalpfad 170. Gemäß dem hier dargestellten Ausführungsbeispiel weist das Steuergerät 130 die erste Wandlereinrichtung 132 und die zweite Wandlereinrichtung 134 auf. Die erste Wandlereinrichtung 132 ist elektrisch bzw. signalübertragungsfähig mit der ersten Ausgangsschnittstelle 144 und somit mit dem ersten Signalpfad 150 der Bereitstellungsvorrichtung 140 verbunden. Die zweite Wandlereinrichtung 134 ist elektrisch bzw. signalübertragungsfähig mit der zweiten Ausgangsschnittstelle 146 und somit mit dem zweiten Signalpfad 170 der Bereitstellungsvorrichtung 140 verbunden.

Gemäß dem hier dargestellten Ausführungsbeispiel weist der erste Signalpfad 150 als elektronische Bauelemente zwei erste elektrische Widerstände R2a und R3a sowie eine erste Kapazität C1a auf. Die beiden ersten elektrischen Widerstände R2a und R3a sind elektrisch miteinander in Reihe geschaltet. Zwischen den beiden ersten elektrischen Widerständen R2a und R3a ist die erste Testeinrichtung 160 elektrisch mit dem ersten Signalpfad 150 verbunden. Zwischen den beiden ersten elektrischen Widerständen R2a und R3a einerseits und der ersten Ausgangsschnittstelle 144 andererseits ist die erste Kapazität C1a elektrisch zwischen den ersten Signalpfad 150 und Masse geschaltet. Der erste Signalpfad 150 erstreckt sich zwischen dem Verzweigungspunkt 143 und der ersten Ausgangsschnittstelle 144.

Die erste Testeinrichtung 160 weist gemäß dem hier dargestellten Ausführungsbeispiel eine erste elektrische Testspannungsquelle 165, einen ersten elektrischen Testwiderstand R1a und eine erste Schalteinrichtung SW1a auf. Die erste elektrische Testspannungsquelle 165 ist ausgebildet, um das erste Testsignal V_TEST_a zu erzeugen. Die erste Schalteinrichtung SW1a ist ausgebildet, um die erste Testeinrichtung 160 signalübertragungsfähig bzw. elektrisch mit dem ersten Signalpfad 150 zu verbinden. Hierbei ist die erste Schalteinrichtung SW1a elektrisch zwischen die erste Testspannungsquelle 165 und den ersten elektrischen Testwiderstand R1a geschaltet. Somit ist der erste elektrische Testwiderstand R1a elektrisch zwischen die erste Schalteinrichtung SW1a und den ersten Signalpfad 150 geschaltet. Alternativ kann der erste elektrische Testwiderstand R1a auch als Teil des ersten Signalpfads 150 betrachtet werden.

Ferner weist gemäß dem hier dargestellten Ausführungsbeispiel weist der zweite Signalpfad 170 als elektronische Bauelemente zwei zweite elektrische Widerstände R2b und R3b sowie eine zweite Kapazität C2b auf. Die beiden zweiten elektrischen Widerstände R2b und R3b sind elektrisch miteinander in Reihe geschaltet. Zwischen den beiden zweiten elektrischen Widerständen R2b und R3b ist die zweite Testeinrichtung 180 elektrisch mit dem zweiten Signalpfad 170 verbunden. Zwischen den beiden zweiten elektrischen Widerständen R2b und R3b einerseits und der zweiten Ausgangsschnittstelle 146 andererseits ist die zweite Kapazität C2b elektrisch zwischen den zweiten Signalpfad 170 und Masse geschaltet. Der zweite Signalpfad 170 erstreckt sich zwischen dem Verzweigungspunkt 143 und der zweiten Ausgangsschnittstelle 146.

Die zweite Testeinrichtung 180 weist gemäß dem hier dargestellten Ausführungsbeispiel eine zweite elektrische Testspannungsquelle 185, einen zweiten elektrischen Testwiderstand R1b und eine zweite Schalteinrichtung SW1b auf. Die zweite elektrische Testspannungsquelle 185 ist ausgebildet, um das zweite Testsignal V_TEST_b zu erzeugen. Die zweite Schalteinrichtung SW1b ist ausgebildet, um die zweite Testeinrichtung 180 signalübertragungsfähig bzw. elektrisch mit dem zweiten Signalpfad 170 zu verbinden. Hierbei ist die zweite Schalteinrichtung SW1b elektrisch zwischen die zweite Testspannungsquelle 185 und den zweiten elektrischen Testwiderstand R1b geschaltet. Somit ist der zweite elektrische Testwiderstand R1b elektrisch zwischen die zweite Schalteinrichtung SW1b und den zweiten Signalpfad 170 geschaltet. Alternativ kann der zweite elektrische Testwiderstand R1b auch als Teil des zweiten Signalpfads 170 betrachtet werden.

Ferner weist die Bereitstellungsvorrichtung 140 gemäß dem hier dargestellten Ausführungsbeispiel einen elektrischen Eingangswiderstand R4 auf. Der elektrische Eingangswiderstand R4 ist zwischen der Eingangsschnittstelle 142 und dem Verzweigungspunkt 143 angeordnet. Dabei ist der Eingangswiderstand R4 elektrisch zwischen die Eingangsschnittstelle 142 und Masse geschaltet.

Gemäß dem hier dargestellten Ausführungsbeispiel weist das Steuergerät 130 die erste elektrische Testspannungsquelle 165, die erste Schalteinrichtung SW1a, die zweite elektrische Testspannungsquelle 185 und die zweite Schalteinrichtung SW1b auf. Gemäß einem anderen Ausführungsbeispiel kann das Steuergerät 130 weitere, andere oder keine Elemente der Bereitstellungsvorrichtung 140 aufweisen.

Nochmals zusammenfassend und anders ausgedrückt liefert der Sensor 120 eine elektrische Spannung als Sensorsignal V_PS, das durch die Bereitstellungsvorrichtung 140 mit dem elektrischen Eingangswiderstand R4 belastet wird. Das Steuergerät 130 ist Beispielsweise als ein Mikrocontroller ausgeführt. Das über den ersten Signalpfad 150 zu dem Steuergerät 130 geführte Sensorsignal V_PS wird beispielsweise an einem ersten Analog-Digital-Wandler-Kanal bzw. an der ersten Wandlereinrichtung 132 ausgewertet. Das über den zweiten Signalpfad 170 zu dem Steuergerät 130 geführte Sensorsignal V_PS wird beispielsweise an einem zweiten Analog-Digital-Wandler-Kanal bzw. an der zweiten Wandlereinrichtung 134 ausgewertet. Wenn die erste Schalteinrichtung SW1a geöffnet ist, fungiert die erste Testeinrichtung 160 als ein hochohmiger Eingang des Steuergerätes 130. Bei geschlossener erster Schalteinrichtung SW1a fungiert die erste Testeinrichtung 160 als ein Ausgang des Steuergerätes 130, wobei über den ersten elektrischen Testwiderstand R1a das Sensorsignal V_PS in dem ersten Signalpfad 150 verändert werden kann, indem das erste Testsignal V_TEST_a mit einem logisch hohen Pegel oder einem logisch niedrigen Pegel erzeugt wird. Sofern dann eine Änderung an dem über den ersten Signalpfad 150 übertragenen Sensorsignal V_PS gemessen wird, kann festgestellt werden, dass der Analog-Digital-Wandler-Kanal bzw. die erste Wandlereinrichtung 132 und der erste Signalpfad 150 prinzipiell funktionieren. Währenddessen kann das Sensorsignal V_PS auf dem zweiten Signalpfad 170 weiterhin kontinuierlich gemessen und ausgewertet werden. Zur Prüfung des zweiten Signalpfads 170 werden Test- und Messpfade vertauscht, d.h. die erste Schalteinrichtung SW1a geöffnet und die zweite Schalteinrichtung SW1b geschlossen.

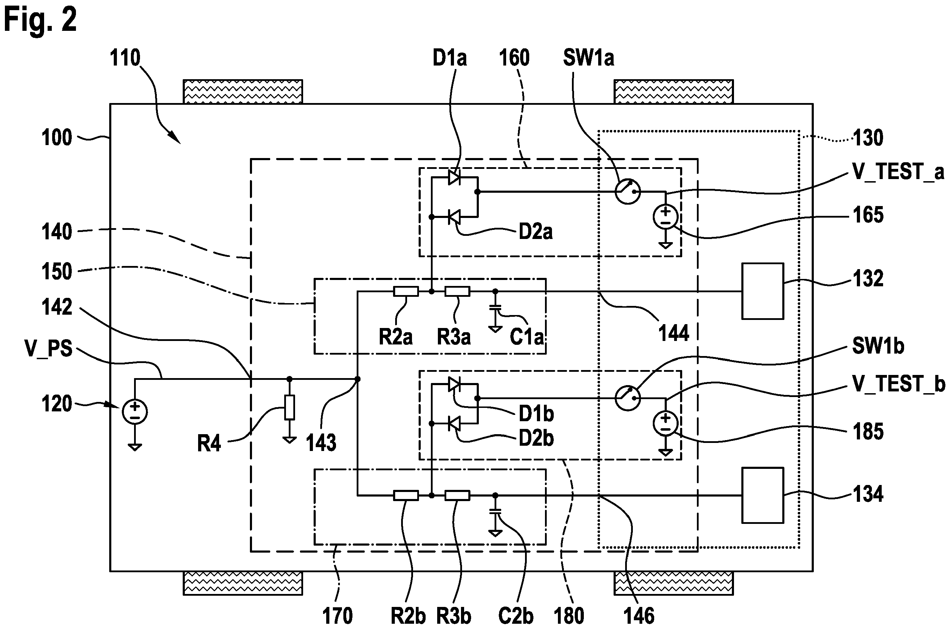

**Fig. 2** zeigt eine schematische Darstellung eines Fahrzeugs 100 mit einem Bremssystem 110 gemäß einem Ausführungsbeispiel. Das Bremssystem 110 entspricht hierbei dem Bremssystem aus Fig. 1 mit Ausnahme dessen, dass die Bereitstellungsvorrichtung 140 anders ausgeführt ist. Genauer gesagt weist die erste Testeinrichtung 160 der Bereitstellungsvorrichtung 140 anstelle des ersten elektrischen Testwiderstands eine Parallelschaltung zweier erster Testdioden D1a und D2a und weist die zweite Testeinrichtung 180 der Bereitstellungsvorrichtung 140 anstelle des zweiten elektrischen Testwiderstands eine Parallelschaltung zweier zweiter Testdioden D1b und D2b auf.

Somit sind die bezüglich einander elektrisch parallel geschalteten ersten Testdioden D1a und D2a elektrisch zwischen die erste Schalteinrichtung SW1a der ersten Testeinrichtung 160 und den ersten Signalpfad 150 geschaltet. Hierbei sind die ersten Testdioden D1a und D2a mit einander entgegengesetzten Durchlassrichtungen elektrisch parallel geschaltet. Ferner sind die bezüglich einander elektrisch parallel geschalteten zweiten Testdioden D1b und D2b elektrisch zwischen die zweite Schalteinrichtung SW1b der zweiten Testeinrichtung 180 und den zweiten Signalpfad 170 geschaltet. Dabei sind die zweiten Testdioden D1b und D2b mit einander entgegengesetzten Durchlassrichtungen elektrisch parallel geschaltet.

Gemäß dem in Fig. 2 dargestellten Ausführungsbeispiel kann unter Verwendung des gleichen Testprozesses wie in Fig. 1 eine genauer definierte Spannung auf das Sensorsignal V_PS in dem ersten Signalpfad 150 bzw. in dem zweiten Signalpfad 170 eingespeist bzw. demselben eingeprägt werden, wie beispielsweise 0,7 Volt bzw. VCC - 0,7 Volt. Verglichen mit einer direkten Einspeisung von logisch hohen Pegeln oder logisch niedrigen Pegeln der Testsignale V_TEST_a und V_TEST_b können so nicht nur Eckwerte der Analog-Digital-Wandler-Kanäle bzw. Wandlereinrichtungen 132 und 134 gemessen werden, sondern auch elektrische Spannungen im gültigen Messbereich. Diese Werte unterscheiden sich somit von möglicherweise geschalteten Kurzschlüssen gegen GND bzw. Masse oder VCC bzw. Versorgungsspannung.

Gemäß einem Ausführungsbeispiel können die Testeinrichtungen 160 bzw. 180 auch jeweils eine Kombination aus den Testwiderständen R1a bzw. R1b und den Testdioden D1a und/oder D2a bzw. D1b und/oder D2b aufweisen. Statt einer Testdiode kann gemäß einem Ausführungsbeispiel auch eine genauere Referenzspannung verwendet werden.

Denkbar ist ferner auch ein Ausführungsbeispiel, in dem die Bauelemente C1a bzw. C2b sind nicht unbedingt nötig sind und auch wegfallen können. In diesem Fall könnte dann beispielsweise ein Mikrocontroller die Filterung vornehmen. Gemäß einem weiteren Ausführungsbeispiel können die Bauelemente D1a, D2a, D1b, D2b auch als Shottky-Dioden, welche die eine niedrigere Durchbruch-Spannung als normale Dioden haben, oder als Zenerdioden ausgestaltet sein. Denkbar ist auch ein Ausführungsbeispiel, bei dem pro Testeinrichtung nur eine Zenerdiode und eine normale Diode verwendet werden, da bei Verwendung von zwei Zenerdioden ansonsten eine Wirkung wie zwei normale Dioden vorliegt. Damit könnte eine feste Prüf-Spannung auch zwischen GND+0,7 V und VCC-0,7V liegen. Die Erzeugung der Prüfspannung kann auch durch den Mikrocontroller erfolgen indem ein Port niederohmig gegen VCC oder GND geschaltet wird.

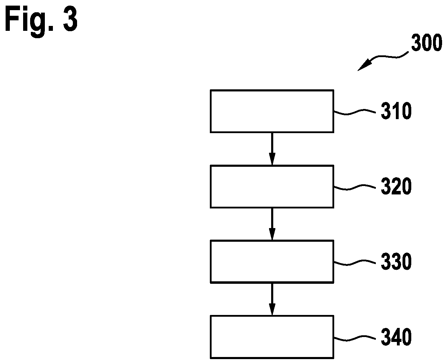

**Fig. 3** zeigt ein Ablaufdiagramm eines Verfahrens 300 zum Auswerten gemäß einem Ausführungsbeispiel. Das Verfahren 300 zum Auswerten ist ausführbar, um ein Sensorsignal für ein Bremssystem eines Fahrzeugs auszuwerten. Dabei ist das Verfahren 300 zum Auswerten In Verbindung mit der Vorrichtung aus einer der vorstehend beschriebenen Figuren oder einer ähnlichen Vorrichtung ausführbar. Ferner ist das Verfahren 300 zum Auswerten mittels des Steuergeräts aus einer der vorstehend beschriebenen Figuren oder eines ähnlichen Steuergeräts ausführbar.

Gemäß dem hier dargestellten Ausführungsbeispiel weist das Verfahren 300 zum Auswerten einen ersten Schritt 310 des Beaufschlagens, einen ersten Schritt 320 des Einlesens, einen zweiten Schritt 330 des Beaufschlagens und einen zweiten Schritt 340 des Einlesens auf.

In dem ersten Schritt 310 des Beaufschlagens wird lediglich das Sensorsignal in dem ersten Signalpfad mit dem ersten Testsignal beaufschlagt. In dem ersten Schritt 320 des Einlesens wird das mit dem ersten Testsignal beaufschlagte Sensorsignal von der ersten Ausgangsschnittstelle eingelesen, um einen Test des ersten Signalpfades und der ersten Wandlereinrichtung durchzuführen, und wird das Sensorsignal von der zweiten Ausgangsschnittstelle eingelesen, um das Sensorsignal auszuwerten. Nachfolgend wird in dem zweiten Schritt 330 des Beaufschlagens lediglich das Sensorsignal in dem zweiten Signalpfad mit dem zweiten Testsignal beaufschlagt. In dem zweiten Schritt 340 des Einlesens wird das mit dem zweiten Testsignal beaufschlagte Sensorsignal von der zweiten Ausgangsschnittstelle eingelesen, um einen Test des zweiten Signalpfades und der zweiten Wandlereinrichtung durchzuführen, und wird das Sensorsignal von der ersten Ausgangsschnittstelle eingelesen, um das Sensorsignal auszuwerten.

Dabei können der erste Schritt 310 des Beaufschlagens und der erste Schritt 320 des Einlesens bezüglich einander zumindest teilweise zeitlich überlappend ausgeführt werden und können der zweite Schritt 330 des Beaufschlagens und der zweite Schritt 340 des Einlesens bezüglich einander zumindest teilweise zeitlich überlappend ausgeführt werden. Nach dem zweiten Schritt 340 des Einlesens kann das Verfahren 300 zum Auswerten erneut bei dem ersten Schritt 310 des Beaufschlagens beginnen.

### BEZUGSZEICHENLISTE

- 100: Fahrzeug
- 110: Bremssystem
- 120: Sensor
- 130: Steuergerät
- 132: erste Wandlereinrichtung
- 134: zweite Wandlereinrichtung
- 140: Vorrichtung
- 142: Eingangsschnittstelle
- 143: Verzweigungspunkt
- 144: erste Ausgangsschnittstelle
- 146: zweite Ausgangsschnittstelle
- 150: erster Signalpfad
- 160: erste Testeinrichtung
- 170: zweiter Signalpfad
- 180: zweite Testeinrichtung
- 165: erste elektrische Testspannungsquelle
- 185: zweite elektrische Testspannungsquelle
- C1a: erste Kapazität
- C2b: zweite Kapazität
- R1a: erster elektrischer Testwiderstand
- R1b: zweiter elektrischer Testwiderstand
- R2a, R3a: erste elektrische Widerstände
- R2b, R3b: zweite elektrische Widerstände
- R4: Eingangswiderstand
- SW1a: erste Schalteinrichtung
- SW1b: zweite Schalteinrichtung
- V_PS: Sensorsignal
- V_TEST_a: erstes Testsignal
- V_TEST_b: zweites Testsignal
- D1a, D2a: erste Testdioden
- D1b, D2b: zweite Testdioden
- 300: Verfahren zum Auswerten
- 310: erster Schritt des Beaufschlagens
- 320: erster Schritt des Einlesens
- 330: zweiter Schritt des Beaufschlagens
- 340: zweiter Schritt des Einlesens

## Patentansprüche

1. Vorrichtung (140) zum Bereitstellen eines Sensorsignals (V_PS) zum Auswerten für ein Bremssystem (110) eines Fahrzeugs (100), wobei die Vorrichtung (140) folgende Merkmale aufweist:
einen ersten Signalpfad (150) zum Ausgeben des Sensorsignals (V_PS) an eine erste Ausgangsschnittstelle (144) zu einer ersten Wandlereinrichtung (132), wobei der erste Signalpfad (150) erste elektronische Bauelemente (C1a, R2a, R3a) aufweist, wobei der erste Signalpfad (150) elektrisch mit einer Eingangsschnittstelle (142) verbunden ist, die zu einem Sensor (120) des Fahrzeugs (100) verbindbar ist;
eine erste Testeinrichtung (160) zum Beaufschlagen des Sensorsignals (V_PS) in dem ersten Signalpfad (150) mit einem ersten Testsignal (V_TEST_a), wobei die erste Testeinrichtung (160) elektrisch mit dem ersten Signalpfad (150) verbindbar oder verbunden ist; **dadurch gekennzeichnet, dass** die Vorrichtung weiter folgende Merkmale aufweist:
einen zweiten Signalpfad (170) zum Ausgeben des Sensorsignals (V_PS) an eine zweite Ausgangsschnittstelle (146) zu einer zweiten Wandlereinrichtung (134), wobei der zweite Signalpfad (170) zweite elektronische Bauelemente (C2b, R2b, R3b) aufweist, wobei der zweite Signalpfad (170) elektrisch mit der Eingangsschnittstelle (142) verbunden ist, die zu dem Sensor (120) des Fahrzeugs (100) verbindbar ist; und
eine zweite Testeinrichtung (180) zum Beaufschlagen des Sensorsignals (V_PS) in dem zweiten Signalpfad (170) mit einem zweiten Testsignal (V_TEST_b), wobei die zweite Testeinrichtung (180) elektrisch mit dem zweiten Signalpfad (170) verbindbar oder verbunden ist.

2. Vorrichtung (140) gemäß Anspruch 1, **dadurch gekennzeichnet, dass** die erste Testeinrichtung (160) eine erste elektrische Testspannungsquelle (165) zum Erzeugen des ersten Testsignals (V_TEST_a) und eine erste Schalteinrichtung (SW1a) zum signalübertragungsfähigen Verbinden der ersten Testeinrichtung (160) mit dem ersten Signalpfad (150) aufweist, wobei die zweite Testeinrichtung (180) eine zweite elektrische Testspannungsquelle (185) zum Erzeugen des zweiten Testsignals (V_TEST_b) und eine zweite Schalteinrichtung (SW1b) zum signalübertragungsfähigen Verbinden der zweiten Testeinrichtung (180) mit dem zweiten Signalpfad (170) aufweist.

3. Vorrichtung (140) gemäß einem der vorangegangenen Ansprüche, **dadurch gekennzeichnet, dass** die erste Testeinrichtung (160) einen ersten elektrischen Testwiderstand (R1a) und/oder eine Parallelschaltung aus einer oder zwei ersten Testdioden (D1a, D2a) aufweist, wobei die zweite Testeinrichtung (180) einen zweiten elektrischen Testwiderstand (R1b) und/oder eine Parallelschaltung aus einer oder zwei zweiten Testdioden (D1b, D2b) aufweist.

4. Vorrichtung (140) gemäß einem der vorangegangenen Ansprüche, **dadurch gekennzeichnet, dass** die ersten elektronischen Bauelemente des ersten Signalpfades (150) zwei erste elektrische Widerstände (R2a, R3a), die miteinander elektrisch in Reihe geschaltet sind, und eine erste Kapazität (C1a) aufweisen, wobei die erste Testeinrichtung (160) zwischen den ersten Widerständen (R2a, R3a) elektrisch mit dem ersten Signalpfad (150) verbunden ist, wobei die erste Kapazität (C1a) zwischen den ersten Widerständen (R2a, R3a) und der ersten Ausgangsschnittstelle (144) elektrisch zwischen den ersten Signalpfad (150) und Masse geschaltet ist, wobei die zweiten elektronischen Bauelemente des zweiten Signalpfades (170) zwei zweite elektrische Widerstände (R2b, R3b), die miteinander elektrisch in Reihe geschaltet sind, und eine zweite Kapazität (C2b) aufweisen, wobei die zweite Testeinrichtung (180) zwischen den zweiten Widerständen (R2b, R3b) elektrisch mit dem zweiten Signalpfad (170) verbunden ist, wobei die zweite Kapazität (C2b) zwischen den zweiten Widerständen (R2b, R3b) und der zweiten Ausgangsschnittstelle (146) elektrisch zwischen den zweiten Signalpfad (170) und Masse geschaltet ist.

5. Vorrichtung (140) gemäß einem der vorangegangenen Ansprüche, **gekennzeichnet durch** einen elektrischen Eingangswiderstand (R4), der elektrisch zwischen die Eingangsschnittstelle (142) und Masse geschaltet ist.

6. Verfahren (300) zum Auswerten eines Sensorsignals (V_PS) für ein Bremssystem (110) eines Fahrzeugs (100), wobei das Verfahren (300) in Verbindung mit der Vorrichtung (140) gemäß einem der vorangegangenen Ansprüche und einem Steuergerät (130) ausgeführt wird, wobei das Verfahren (300) folgende Schritte aufweist:
Beaufschlagen (310) lediglich des Sensorsignals (V_PS) in dem ersten Signalpfad (150) mit dem ersten Testsignal (V_TEST_a);
Einlesen (320) in das Steuergerät des mit dem ersten Testsignal (V_TEST_a) beaufschlagten Sensorsignals (V_PS) von der ersten Ausgangsschnittstelle (144), um einen Test des ersten Signalpfades (150) und der ersten Wandlereinrichtung (132) durchzuführen, und des Sensorsignals (V_PS) von der zweiten Ausgangsschnittstelle (146), um das Sensorsignal (V_PS) auszuwerten;
nachfolgend Beaufschlagen (330) lediglich des Sensorsignals (V_PS) in dem zweiten Signalpfad (170) mit dem zweiten Testsignal (V_TEST_b); und
Einlesen (340) in das Steuergerät des mit dem zweiten Testsignal (V_TEST_b) beaufschlagten Sensorsignals (V_PS) von der zweiten Ausgangsschnittstelle (146), um einen Test des zweiten Signalpfades (170) und der zweiten Wandlereinrichtung (134) durchzuführen, und des Sensorsignals (V_PS) von der ersten Ausgangsschnittstelle (144), um das Sensorsignal (V_PS) auszuwerten.

7. Steuergerät (130), das eingerichtet ist, um die Schritte des Verfahrens (300) gemäß Anspruch 6 mit der Vorrichtung (140) gemäß einem der Ansprüche 1 bis 5 auszuführen und/oder anzusteuern,

8. Bremssystem (110) für ein Fahrzeug (100), wobei das Bremssystem (110) folgende Merkmale aufweist:
einen Sensor (120), wobei der Sensor (120) ausgebildet ist, um ein Sensorsignal (V_PS) auszugeben;
die Vorrichtung (140) gemäß einem der Ansprüche 1 bis 5; und
das Steuergerät (130) gemäß Anspruch 7, wobei der Sensor (120) über die Vorrichtung (140) signalübertragungsfähig mit dem Steuergerät (130) verbunden ist.

9. Bremssystem (110) gemäß Anspruch 8, **dadurch gekennzeichnet, dass** das Steuergerät (130) die erste Wandlereinrichtung (132) und die zweite Wandlereinrichtung (134) aufweist.

10. Bremssystem (110) gemäß einem der Ansprüche 8 bis 9, **dadurch gekennzeichnet, dass** das Steuergerät (130) zumindest Teile der ersten Testeinrichtung (160) der Vorrichtung (140) und zumindest Teile der zweiten Testeinrichtung (180) der Vorrichtung (140) aufweist.

11. Computerprogramm, das computerausführbare Befehle beinhaltet, die wenn sie auf einem Steuergerät gemäß Anspruch 7 ausgeführt werden, das Verfahren (300) gemäß Anspruch 6 ausführen und/oder ansteuern.

12. Maschinenlesbares Speichermedium, auf dem das Computerprogramm nach Anspruch 11 gespeichert ist.

## Claims

1. Apparatus (140) for providing a sensor signal (V_PS) for evaluation for a braking system (110) of a vehicle (100), wherein the apparatus (140) has the following features:
a first signal path (150) for outputting the sensor signal (V_PS) to a first output interface (144) to a first converter device (132), wherein the first signal path (150) has first electronic components (C1a, R2a, R3a), wherein the first signal path (150) is electrically connected to an input interface (142) which is connectable to a sensor (120) of the vehicle (100);
a first test device (160) for applying a first test signal (V_TEST_a) to the sensor signal (V_PS) in the first signal path (150), wherein the first test device (160) can be or is electrically connectable to the first signal path (150);
**characterized in that** the apparatus has the following further features:
a second signal path (170) for outputting the sensor signal (V_PS) to a second output interface (146) to a second converter device (134), wherein the second signal path (170) has second electronic components (C2b, R2b, R3b), wherein the second signal path (170) is electrically connected to the input interface (142) which is connectable to the sensor (120) of the vehicle (100); and
a second test device (180) for applying a second test signal (V_TEST_b) to the sensor signal (V_PS) in the second signal path (170), wherein the second test device (180) can be or is electrically connected to the second signal path (170).

2. Apparatus (140) according to Claim 1, **characterized in that** the first test device (160) has a first electrical test voltage source (165) for generating the first test signal (V_TEST_a) and a first switching device (SW1a) for connecting the first test device (160) to the first signal path (150) with signal transmission capability, wherein the second test device (180) has a second electrical test voltage source (185) for generating the second test signal (V_TEST_b) and a second switching device (SW1b) for connecting the second test device (180) to the second signal path (170) with signal transmission capability.

3. Apparatus (140) according to one of the preceding claims, **characterized in that** the first test device (160) has a first electrical test resistor (R1a) and/or a parallel circuit comprising one or two first test diodes (D1a, D2a), wherein the second test device (180) has a second electrical test resistor (R1b) and/or a parallel circuit comprising one or two second test diodes (D1b, D2b).

4. Apparatus (140) according to one of the preceding claims, **characterized in that** the first electronic components of the first signal path (150) have two first electrical resistors (R2a, R3a), which are electrically connected in series with one another, and a first capacitance (C1a), wherein the first test device (160) is electrically connected to the first signal path (150) between the first resistors (R2a, R3a), wherein , between the first resistors (R2a, R3a) and the first output interface (144), the first capacitance (C1a) is electrically connected between the first signal path (150) and ground, wherein the second electronic components of the second signal path (170) have two second electrical resistors (R2b, R3b), which are electrically connected in series with one another, and a second capacitance (C2b), wherein the second test device (180) is electrically connected to the second signal path (170) between the second resistors (R2b, R3b), wherein, between the second resistors (R2b, R3b) and the second output interface (146), the second capacitance (C2b) is electrically connected between the second signal path (170) and ground.

5. Apparatus (140) according to one of the preceding claims,
**characterized by** an electrical input resistor (R4), which is electrically connected between the input interface (142) and ground.

6. Method (300) for evaluating a sensor signal (V_PS) for a braking system (110) of a vehicle (100), wherein the method (300) is executed in conjunction with the apparatus (140) according to one of the preceding claims, and in conjunction with a control unit (130), wherein the method (300) has the following steps of:
applying (310) the first test signal (V_TEST_a) only to the sensor signal (V_PS) in the first signal path (150);
reading in (320) to the control unit of the sensor signal (V_PS), to which the first test signal (V_TEST_a) has been applied, from the first output interface (144), in order to test the first signal path (150) and the first controller device (132), and reading in the sensor signal (V_PS) from the second output interface (146) in order to evaluate the sensor signal (V_PS);
applying (300) the second test signal (V_TEST_b) only to the sensor signal (V_PS) in the second signal path (170); and
reading in (340) to the control unit of the sensor signal (V_PS), to which the second test signal (V_TEST_b) has been applied, from the second output interface (146), in order to test the second signal path (170) and the second converter device (134), and reading in the sensor signal (V_PS) from the first output interface (144), in order to evaluate the sensor signal (V_PS)

7. Control unit (300) which is configured to carry out and/or control steps of the method (300) according to Claim 6, by means of the apparatus (140) according to one of Claims 1 to 5.

8. Braking system (110) for a vehicle (100), wherein the braking system (110) has the following features:
a sensor (120), wherein the sensor (120) is designed to output a sensor signal (V_PS);
the apparatus (140) according to one of Claims 1 to 5; and
the control unit (130) according to Claim 7, wherein the sensor (120) is connected to the control unit (130) with signal transmission capability via the apparatus (140).

9. Braking system (110) according to Claim 8, **characterized in that** the control unit (130) has the first converter device (132) and the second converter device (134).

10. Braking system (110) according to one of Claims 8 or 9, **characterized in that** the control unit (130) has at least parts of the first test device (160) of the apparatus (140) and at least parts of the second test device (180) of the apparatus (140).

11. Computer program comprising computer-executable commands which, by the running thereof on a control unit according to Claim 7, executes and/or controls the method (300) according to Claim 6.

12. Machine-readable storage medium, on which the computer program according to Claim 11 is stored.

## Revendications

1. Montage (140) de mise à disposition d'un signal (V_PS) de capteur à évaluer d'un système (110) de frein d'un véhicule (100), dans lequel le montage (140) a les caractéristiques suivantes :
un premier chemin (150) du signal pour l'envoi du signal (V_PS) de capteur sur une première interface (144) de sortie à un premier dispositif (132) convertisseur, dans lequel le premier chemin (150) du signal a des premiers composants (C1a, R2a, R3a) électroniques, dans lequel le premier chemin (150) du signal est relié électriquement à une interface (142) d'entrée, qui peut être reliée à un capteur (120) du véhicule (100) ;
un premier dispositif (160) de test pour l'alimentation du signal (V_PS) de capteur, dans le premier chemin (150) du signal, en un premier signal (V_TEST_a) de test, dans lequel le premier dispositif (160) de test est relié électriquement au premier chemin (150) du signal ou peut l'être ;
**caractérisé en ce que** le montage a en outre les caractéristiques suivantes :
un deuxième chemin (170) du signal pour l'envoi du signal (V_PS) de capteur sur une deuxième interface (146) de sortie à un deuxième dispositif (134) convertisseur, dans lequel le deuxième chemin (170) du signal a des deuxièmes composants (C2b, R2b, R3b) électroniques, dans lequel le deuxième chemin (170) du signal est relié électriquement à l'interface (142) d'entrée, qui peut être reliée au capteur (120) du véhicule (100) ; et
un deuxième dispositif (180) de test pour l'alimentation du signal (V_PS) de capteur, dans le deuxième chemin (170) du signal, en un deuxième signal (V_TEST_b) de test, dans lequel le deuxième dispositif (180) de test est relié au deuxième chemin (170) du signal ou peut l'être.

2. Montage (140) suivant la revendication 1, **caractérisé en ce que** le premier dispositif (160) de test a une première source (165) de tension de test électrique pour la production du premier signal (V_TEST_a) de test et un premier dispositif (SW1a) de coupure pour la liaison, avec possibilité de transmission du signal, du premier dispositif (160) de test avec le premier chemin (150) du signal, dans lequel le deuxième dispositif (180) de test a une deuxième source (185) de tension de test électrique pour la production du deuxième signal (V_TEST_b) de test et un deuxième dispositif (SW1b) de coupure pour la liaison, avec possibilité de transmission du signal, du deuxième dispositif (180) de test au deuxième chemin (170) du signal.

3. Montage (140) suivant l'une des revendications précédentes, **caractérisé en ce que** le premier dispositif (160) de test a une première résistance (R1a) électrique de test et/ou un circuit en parallèle composé d'une ou de deux premières diodes (D1a, D2a) de test, dans lequel le deuxième dispositif (180) de test a une deuxième résistance (R1b) électrique de test et/ou un circuit en parallèle composé d'une ou de deux deuxièmes diodes (D1b, D2b) de test.

4. Montage (140) suivant l'une des revendications précédentes, **caractérisé en ce que** les premiers composants électroniques du premier chemin (150) du signal ont deux premières résistances (R2a, R3a) électriques, qui sont montées entre elles électriquement en série, et une première capacité (C1a), dans lequel le premier dispositif (160) de test est, entre les premières résistances (R2a, R3a), relié électriquement au premier chemin (150) du signal, dans lequel la première capacité (C1a) est, entre les premières résistances (R2a, R3a) et la première interface (144) de sortie, montée électriquement entre le premier chemin (150) du signal et la masse, dans lequel les deuxièmes composants électroniques du deuxième chemin (170) du signal ont deux deuxièmes résistances (R2b, R3b) électriques, qui sont montées entre elles électriquement en série, et une deuxième capacité (C2b), dans lequel le deuxième dispositif (180) de test est, entre les deux résistances (R2b, R3b), reliée électriquement au deuxième chemin (170) du signal, dans lequel la deuxième capacité (C2b) est, entre les deux résistances (R2b, R3b) et la deuxième interface (146) de sortie, montée électriquement entre le deuxième chemin (170) du signal et la masse.

5. Montage (140) suivant l'une des revendications précédentes, **caractérisé par** une résistance (R4) électrique d'entrée, qui est montée électriquement entre l'interface (142) d'entrée et la masse.

6. Procédé (300) d'évaluation d'un signal (V_PS) de capteur d'un système (110) de frein d'un véhicule (100), dans lequel on effectue le procédé (300) en liaison avec le montage (140) suivant l'une des revendications précédentes et avec un appareil (130) de commande,
dans lequel le procédé (300) a les stades suivants :
alimentation (310) seulement du signal (V_PS) de capteur dans le premier chemin (150) du signal en le premier signal (V_TEST_a) de test ;
lecture (320) dans l'appareil de commande du signal (V_PS) de capteur alimenté en le premier signal (V_TEST_a) de test par la première interface (144) de sortie, pour effectuer un test du premier chemin (150) du signal et du premier dispositif (132) convertisseur, et du signal (V_PS) de capteur par la deuxième interface (146) de sortie, pour évaluer le signal (V_PS) de capteur ;
ensuite alimentation (330) seulement du signal (V_PS) de capteur dans le deuxième chemin (170) du signal en le deuxième signal (V_TEST_b) de test ; et
lecture (340) dans l'appareil de commande du signal (V_PS) de capteur alimenté en le deuxième signal (V_TEST_b) de test par la deuxième interface (146) de sortie pour effectuer un test du deuxième chemin (170) du signal et du deuxième dispositif (134) convertisseur, et du signal (V_PS) de capteur par la première interface (144) de sortie, pour évaluer le signal (V_PS) de capteur.

7. Appareil (130) de commande, qui est agencé pour effectuer et/ou commander le procédé (300) suivant la revendication 6 par le montage (140) suivant l'une des revendication 1 à 5.

8. Système (110) de frein d'un véhicule (100), dans lequel le système (110) de frein a les caractéristiques suivantes :
un capteur (120), dans lequel le capteur (120) est constitué pour envoyer un signal (V_PS) de capteur ;
le montage (140) suivant l'une des revendications 1 à 5 ; et
l'appareil (130) de commande suivant la revendication 7, dans lequel le capteur (120) est relié à l'appareil (130) de commande, de manière à pouvoir transmettre le signal par l'intermédiaire du montage (140).

9. Système (110) de frein suivant la revendication 8, **caractérisé en ce que** l'appareil (130) de commande a le premier dispositif (132) convertisseur et le deuxième dispositif (134) convertisseur.

10. Système (110) de frein suivant l'une des revendications 8 à 9, **caractérisé en ce que** l'appareil (130) de commande a au moins des parties du premier dispositif (160) de test du montage (140) et au moins des parties du deuxième dispositif (180) de test du montage (140).

11. Programme d'ordinateur, qui comprend des instructions pouvant être exécutées par ordinateur qui, lorsqu'elles sont exécutées sur un appareil de commande suivant la revendication 7, exécutent ou commandent le procédé (300) suivant la revendication 6.

12. Support de mémoire, déchiffrable par une machine, sur lequel le programme d'ordinateur suivant la revendication 11 est mis en mémoire.
